# EUROPEAN PATENT APPLICATION

(11) **EP 4 746 629 A1**
(43) Date of publication of application: **20.05.2026**
(21) Application number: 25215531.2
(22) Date of filing: 13.11.2025
(51) Int. Cl.: H10D 30/47, H10D 30/01, H10D 62/80, H10D 64/27, H10D 62/82, H10D 64/68

(54) **SEMICONDUCTOR DEVICE, METHOD OF MANUFACTURING THE SAME, AND ELECTRONIC DEVICE INCLUDING THE SEMICONDUCTOR DEVICE**

(30) Priority: 15.11.2024 KR 20240163349
(71) Applicant: Samsung Electronics Co., Ltd., Suwon-si, Gyeonggi-do 16677 (KR)
(72) Inventor: Kwon, Junyoung, 16678 Suwon-si, Gyeonggi-do (KR); Kim, Changhyun, 16678 Suwon-si, Gyeonggi-do (KR); Ryu, Huije, 16678 Suwon-si, Gyeonggi-do (KR); Park, Baekwon, 16678 Suwon-si, Gyeonggi-do (KR); Yoo, Minseok, 16678 Suwon-si, Gyeonggi-do (KR); Lee, Hyunmi, 16678 Suwon-si, Gyeonggi-do (KR)
(74) Representative: Grünecker Patent- und Rechtsanwälte PartG mbB

(57) **Abstract**

Provided is a semiconductor device including a channel layer including a van der Waals material, an interlayer arranged on the channel layer and including a semiconductor or an insulator, and a dopant, a gate insulating layer arranged on the interlayer, and a gate electrode arranged on the gate insulating layer.

## Description

### BACKGROUND

### 1. Field

The disclosure relates to a semiconductor device, a method of manufacturing the same, and an electronic device including the semiconductor device.

### 2. Description of the Related Art

Transistors in semiconductor devices, with an electrical switching function, are used in various integrated circuit devices including memory devices, driving integrated circuits (ICs), logic devices, etc. In order to improve the integration degree of an IC device, a space occupied by a transistor included therein has been rapidly reducing. As such, a channel length of the transistor is reduced, and thicknesses of layers forming the transistor are also reduced.

As described above, in order to reduce short channel effects generated as a field effect transistor (FET) is being miniaturized and to improve gate controllability, research is being conducted on replacement of FET channel materials with a two-dimensional semiconductor.

However, because a two-dimensional material is very thin, doping the two-dimensional material is relatively difficult; thereby controlling the doping concentration is also difficult. Controlling of a doping concentration relates to, for example, adjusting of a threshold voltage of a transistor. A transistor included in an actual logic product may be requested to have at least six threshold voltages. Accordingly, there is demand for a method of reliably adjusting a threshold voltage while utilizing a two-dimensional material as a channel of a transistor.

### SUMMARY

The invention is what is claimed in the independent claims. Preferred embodiments are specified in the dependent claims.

Provided are a semiconductor device and a method of manufacturing the semiconductor device by using a two-dimensional semiconductor material.

Additional aspects will be set forth in part in the description which follows and, in part, will be apparent from the description, or may be learned by practice of the presented embodiments of the disclosure.

According to at least one example embodiment, a semiconductor device includes a channel layer including a van der Waals material; an interlayer on the channel layer, the interlayer including at least one of a semiconductor or an insulator, and a dopant in the at least one of the semiconductor or insulator; a gate insulating layer on the interlayer, and a gate electrode on the gate insulating layer such that the gate insulating layer separates the gate electrode from the interlayer.

The channel layer may include at least one of a two-dimensional semiconductor, graphene, carbon nano-tube, or phosphorene.

The two-dimensional semiconductor may include at least one MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂.

The interlayer may be configured as a seed layer with respect to the gate insulating layer, and as doping layer with respect to the channel layer.

The interlayer may include a physical vapor deposition (PVD) deposited material formed directly on the channel layer.

The interlayer may include at least one of Si, Ge, or a group III-V semiconductor compound.

A doping concentration of a dopant in the interlayer may be 1×10¹³ per cubic centimeter (cm⁻³) or greater.

The interlayer may have a thickness of 1 nanometer nm or less.

The semiconductor device may further include a lower gate electrode under the channel layer, and a lower gate insulating layer between the lower gate electrode and the channel layer.

The semiconductor device may further include a lower interlayer between the channel layer and the lower gate insulating layer, the lower interlayer including at least one of a semiconductor or an insulator, and a dopant in the at least one of the semiconductor or insulator.

The channel layer may be a first channel layer, and the semiconductor device may include a second channel layer spaced apart the first channel layer; the interlayer may be a first interlayer surrounding the first channel layer, and the semiconductor device may include a second interlayer surrounding the second channel layer, and the gate electrode may surround each of the first interlayer and the second interlayer.

According to at least one example embodiment, a semiconductor device includes a substrate, and a first transistor and a second transistor on the substrate, the first transistor and the second transistor spaced apart from each other, wherein the first transistor and the second transistor each independently may include a channel layer including a van der Waals material, an interlayer on the channel layer, the interlayer including at least one of a semiconductor or an insulator, and a dopant in the at least one of the semiconductor or insulator, a gate insulating layer on the interlayer, and a gate electrode on the gate insulating layer such that the gate insulating layer separates the gate electrode from the interlayer.

The first transistor may be an N-type field-effect transistor (FET) and the second transistor is a P-type FET.

The first transistor and the second transistor may represent threshold voltages of a substantially same magnitude.

A doping concentration of the dopant in the interlayer in the first transistor may be different from a doping concentration of the dopant in the interlayer of the second transistor.

The first transistor and the second transistor may represent different threshold voltages.

The channel layer of the first transistor and the channel layer of the second transistor may include a same base material, and a doping concentration of the dopant in the interlayer in the first transistor may be different from a doping concentration of the dopant in the interlayer of the second transistor.

In each of the first transistor and the second transistor, the channel layer may be a first channel layer, and a second channel layer may be spaced apart from the first channel layer, and the interlayer may be a first interlayer surrounding the first channel layer and a second interlayer may surround the second channel layer, and the gate electrode may surround each of the first interlayer and the second interlayer.

According to at least one example embodiment, a method of manufacturing a semiconductor device, includes providing a channel layer including a van der Waals material, forming an interlayer on the channel layer, the interlayer including at least one of a semiconductor or an insulator, and a dopant in the at least one of the semiconductor or insulator, forming a gate insulating layer on the interlayer, and forming a gate electrode on the gate insulating layer.

The forming of the interlayer may use a physical vapor deposition (PVD) method.

A concentration of the dopant contained in the interlayer may be 1×10¹³ cm⁻³ or greater.

The interlayer may have a thickness of 1 nm or less.

According to at least one example embodiment, an electronic device includes at least one semiconductor device, and a controller configured to control the at least one semiconductor device, wherein the at least one semiconductor device includes a channel layer including a van der Waals material; an interlayer on the channel layer, the interlayer including at least one of a semiconductor or an insulator, and a dopant in the at least one of the semiconductor or insulator; a gate insulating layer on the interlayer, and a gate electrode on the gate insulating layer such that the gate insulating layer separates the gate electrode from the interlayer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view schematically showing a structure of a semiconductor device according to at least one example embodiment;
FIG. 2 is an enlarged view of a part of FIG. 1;
FIG. 3 is a graph showing a result of an experiment of a threshold voltage according to a doping state of an interlayer included in the semiconductor device, according to at least one example embodiment;
FIG. 4 is a cross-sectional view schematically showing a structure of a semiconductor device according to at least one example embodiment;
FIG. 5 is a cross-sectional view schematically showing a structure of a semiconductor device according to at least one example embodiment;
FIG. 6 is an enlarged view of a part of FIG. 5;
FIG. 7 is a cross-sectional view schematically showing a structure of a semiconductor device according to at least one example embodiment;
FIG. 8 is a cross-sectional view showing the semiconductor device of FIG. 7 at a different cross-section;
FIG. 9 is a cross-sectional view schematically showing a structure of a semiconductor device according to at least one example embodiment;
FIG. 10 is a flowchart schematically illustrating a method of manufacturing a semiconductor device, according to at least one example embodiment;
FIG. 11 is a schematic block diagram of a display driver integrated circuit (IC) (DDI) and a display apparatus including the DDI, according to at least one example embodiment;
FIG. 12 is a circuit diagram of a complementary metal oxide semiconductor (CMOS) inverter according to at least one example embodiment;
FIG. 13 is a circuit diagram of a CMOS static random-access memory (SRAM) device according to at least one example embodiment;
FIG. 14 is a circuit diagram of a CMOS NAND circuit according to at least one example embodiment;
FIG. 15 is a block diagram of an electronic apparatus according to at least one example embodiment; and
FIG. 16 is a block diagram of an electronic device according to at least one example embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The disclosure will be described in detail below with reference to accompanying drawings. Embodiments described herein are capable of various modifications and may be embodied in many different forms. In the drawings, like reference numerals denote like components, and sizes of components in the drawings may be exaggerated for convenience of explanation. Additionally, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry. Further, whenever a range of values is enumerated, the range includes all values within the range as if recorded explicitly clearly, and may further include the boundaries of the range. Accordingly, a range of "X" to "Y" includes all values between X and Y, including X and Y, unless expressly indicated otherwise.

Hereinafter, it will be understood that when a layer, region, or component is referred to as being "above" or "on" another layer, region, or component, it may be in contact with and directly on the other layer, region, or component, and intervening layers, regions, or components may be present. Additionally, spatially relative terms, such as upper, lower, side, etc. are represented based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural unless it has a clearly different meaning in the context. It will be further understood that when a portion is referred to as "comprising" another component, the portion may not exclude another component but may further comprise another component unless the context states otherwise.

Also, the use of functional terms, like "... unit", "... module", etc., used herein specify a unit for processing at least one function or operation, and this may be implemented with processing circuitry, such as hardware, software, and/or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC) a programmable logic unit, a microprocessor, or an application-specific integrated circuit (ASIC), etc.

The use of the term of "the above-described" and similar indicative terms may correspond to both the singular forms and the plural forms.

Also, the steps of all methods described herein may be performed in any suitable order unless otherwise indicated herein or otherwise clearly contradicted by context.

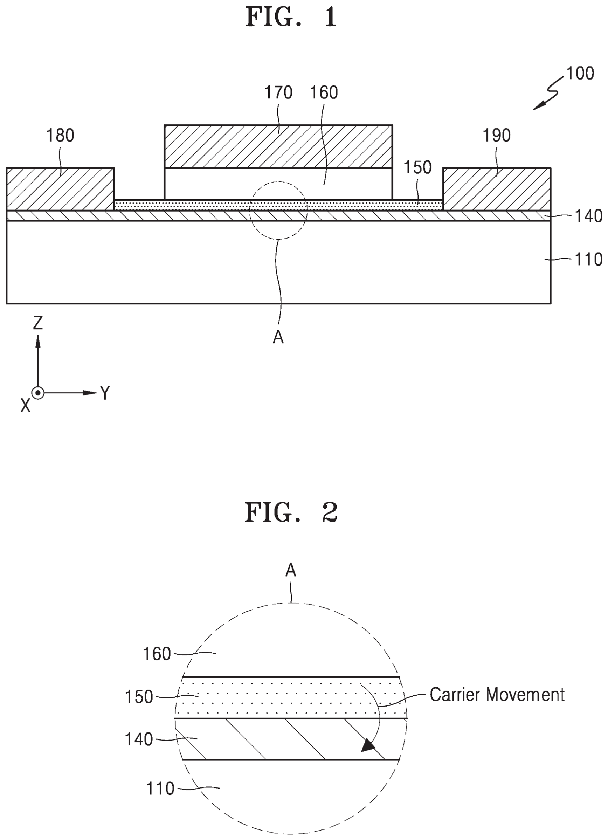

FIG. 1 is a cross-sectional view schematically showing a structure of a semiconductor device 100 according to at least one example embodiment, and FIG. 2 is an enlarged view of a part of FIG. 1.

The semiconductor device 100 includes a channel layer 140, an interlayer 150, a gate insulating layer 160, and a gate electrode 170. The semiconductor device 100 may also include a source electrode 180 and a drain electrode 190 that are electrically connected to opposite ends of the channel layer 140, and the channel layer 140 may be disposed on a substrate 110. The semiconductor device 100 may include (and/or be) a field-effect transistor (FET).

The substrate 110 may include at least one of an insulating substrate, and/or a semiconductor substrate having an insulating layer formed on the surface thereof. The semiconductor substrate may include, for example, Si, Ge, SiGe, a group III-V semiconductor material, etc. The substrate 110 may include, for example, a silicon substrate having a silicon oxide formed on the surface thereof, but is not limited thereto.

The channel layer 140 is disposed on the substrate 110 and may be insulated by the insulating material included in the substrate. For example, in at least some example embodiments, the channel layer 140 may come into contact with the insulating material included in the substrate 110. The channel layer 140 may include a van der Waals material. The van der Waals material is a material having (or forming) a van der Waals surface. The channel layer 140 may include, for example, a two-dimensional material, such as graphene, carbon nano-tube, phosphorene, a transition metal dichalcogenides (TMD), and/or amorphous Boron nitride. The above materials have relatively excellent electrical properties, and thus, characteristics thereof are not largely changed, and high mobility may be maintained even when a thickness is reduced to a nano-scale.

The channel layer 140, according to at least some example embodiments, may include the transition metal dichalcogenides (TMD) material that is a two-dimensional semiconductor material. The TMD may include a transition metal element (e.g., Mo, W, Nb, V, Ta, Ti, Zr, Hf, Tc, Re, Cu, Ga, In, Sn, Ge, and/or Pb) and a chalcogen element (e.g., S, Se, and/or Te). The channel layer 140 may include, for example, MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂.

The van der Waals material is used in the channel layer 140 in order to implement a small thickness for the short channel length when the semiconductor device 100 is applied as an FET. The channel length denotes a length of the channel layer in a direction in which the source electrode 180 and the drain electrode 190 are spaced apart (e.g., the Y-direction). Recently, the channel length has been reduced according to a miniaturization trend of electronic devices. It is known that, as the channel length become shorter, issues due to a short channel effect occur. It is advantageous to reduce a thickness of the channel layer 140 in order to effectively reduce the channel length and to prevent the above issues.

The channel layer 140 is shown as a monolayer, but the examples are not limited thereto, and may have a multilayer or tri-layer structure. Each layer in the channel layer 140 may have a thickness of an atomic level. For example, in these cases, each of the layers may be bonded through van der Waals forces, and without covalent or ionic bonds between the layers. The number of layers may be set in consideration of a channel performance and a total thickness.

The channel layer 140 may have a thickness of about 10 nm or less, e.g., 5 nm or less, or 3 nm or less. The channel length may be 10 nm or less, or 8 nm or less. Alternatively, the channel length may be 7 nm or less, 5 nm or less, or 3 nm or less. However, one or more embodiments are not limited to the above examples.

The channel layer 140 may include charge carriers for adjusting a mobility. The amount of charge carriers formed in the channel layer 140 may be adjusted by the interlayer 150 formed on the channel layer 140. That is, the amount of the charge carriers formed in the channel layer 140 may be determined according to the material forming the interlayer 150 and a concentration of a dopant doped on the interlayer 150. The charge carriers may be referred to as electrons or holes, based on the type of dopant, as discussed in further detail below.

The interlayer 150 is disposed on the channel layer 140 and may be formed to come into contact with the channel layer 140. The interlayer 150 may include a semiconductor or an insulator, and a dopant doped on the above materials. A doping concentration of the dopant in the interlayer 150 may be, for example, 1×10¹³ cm⁻³ or greater, but is not limited thereto. The interlayer 150 may include at least one of Si, Ge, and/or a group III-V semiconductor compound. The dopant may be selected as a material selected to transfer electrons or holes in relation with the material included in the interlayer 150. For example, when the interlayer 150 includes silicon (Si), boron (B) may be used as a p-type dopant; and nitrogen (N) or arsenic (As) may be used as an n-type dopant.

According to at least some example embodiments, the interlayer 150 may include a material that may be formed by a physical vapor deposition (PVD) method. In other words, the interlayer 150 may be formed by the PVD method. The interlayer 150 may be formed by, for example, a thermal evaporation and/or an e-beam evaporation method, or may be formed by a sputtering method. However, one or more embodiments are not limited thereto, and the interlayer 150 may be formed by the method such as an atomic layer deposition (ALD) method and/or a chemical vapor deposition (CVD) method provided that a desired dopant may be appropriately added to the interlayer 150.

The interlayer 150 may be formed by, for example, evaporating a target material doped with a certain type and concentration. During the forming processes, the interlayer 150 may supply charge carries to the channel layer 140.

A work function of the interlayer 150 may be finely adjusted according to the dopant included in the interlayer 150, that is, a dopant of the target material, and accordingly, the doping concentration of the channel layer 140 may be adjusted.

In general, doping of the two-dimensional semiconductor material is very difficult, and accordingly, setting a desired threshold voltages for the FET using the two-dimensional semiconductor material as a channel is difficult.

A substitutional doping is known as a method of controlling the doping concentration of the two-dimensional semiconductor material. According to the substitutional doping, one more or less valence electrons replace atoms constituting the two-dimensional material, so as to perform n-type or p-type doping. The above method is advantageous for a heavy doping because the doping concentration may be greatly increased. However, in the case of the two-dimensional material, a large strain in the two-dimensional material's structure is applied even when only some atoms are replaced to thereby changing the crystallization structure, and characteristics of the two-dimensional material may be lost easily.

The interlayer 150 included in the semiconductor device 100 is formed adjacent to the channel layer 140 and may therefor transfer charge carriers (e.g., electrons or holes) to the channel layer 140. Also, an amount of electrons or holes transferred to the channel layer 140 may be adjusted according to the doping concentration of the interlayer 150, and the doping concentration of the channel layer 140 may be variously adjusted.

The interlayer 150 may also act as a seed layer with respect to the gate insulating layer 160. The channel layer 140 including the van der Waals material may be chemically bonded only in-plane and is chemically noble in out-of-plane direction, and thus, conformally depositing a dielectric material directly on the channel layer 140 is difficult. For example, when the ALD technique that is mainly used to deposit the dielectric material is used, forming initial nuclei is difficult and a conformal thin film may not be formed.

Therefore, in the semiconductor device 100, the interlayer 150 that is formed to be in a physisorption state onto the channel layer 140 to a small thickness may function as a nuclei seeding when forming the gate insulating layer 160.

The interlayer 150 may be set to have an appropriate thickness so as to act as a seed layer for forming the gate insulating layer 160 and as a doping layer for supplying carriers to the channel layer 140. The thickness of the interlayer 150 may be greater than 0 nanometers nm and 2 nm or less. For example, the thickness may be 1.5 nm or less and/or 1 nm or less. However, the example embodiments are not limited to the above examples.

The gate insulating layer 160 is arranged on the interlayer 150. The gate insulating layer 160 may include various kinds of insulating materials. The insulating material may include a high-k dielectric material having high dielectric constant, and/or may include aluminum oxide, hafnium oxide, zirconium oxide, lanthanum oxide, etc. However, the example embodiments are not limited to the above examples. The insulating material may include a ferroelectric material. The ferroelectric material has a spontaneous dipole (electric dipole), that is, a spontaneous polarization, in a crystallized material structure because the charge distribution in a unit cell is non-centrosymmetric. Thus, the ferroelectric material has a remnant polarization due to dipoles even when no external electric field is applied to the ferroelectric material. In addition, the direction of polarization may be switched on a domain basis by an external electric field. The ferroelectric material may include, for example, at least one oxide selected from hafnium (Hf), silicon (Si), aluminum (Al), zirconium (Zr), yttrium (Y), lanthanum (La), gadolinium (Gd), strontium (Sr), and/or the like. However, these materials are examples. In addition, the ferroelectric material may further include a dopant.

When the ferroelectric material is used as the gate insulating material, the semiconductor device 100 may be a field-effect transistor that is applied to a logic device or a memory device. Because a subthreshold swing (SS) of the semiconductor device 100 may be lowered by the negative capacitance effect due to the ferroelectric material, the semiconductor device 100 may act as a field-effect transistor having improved performance and reduced size.

The gate insulating material may have a multilayer structure including a high-k material and/or a ferroelectric material.

The gate insulating layer 160 may be formed by the ALD method. A thickness of the gate insulating layer 160 may be about 10 nm or less, or 5 nm or less. However, one or more embodiments are not limited to the above example.

The gate electrode 170 may include a zero-band gap material, such as a metal material and/or a conductive oxide. The metal material may include at least one of, for example, Au, Ti, TiN, TaN, W, Mo. WN, Pt, and Ni. The conductive oxide may include, for example, at least one of indium tin oxide (ITO), indium zinc oxide (IZO), etc.

The source electrode 180 and the drain electrode 190 may include a zero-band gap material, such as a metal material having electric conductivity. For example, the source electrode 180 and the drain electrode 190 may each include metal such as at least one of magnesium (Mg), aluminum (Al), scandium (Sc), titanium (Ti), vanadium (V), chrome (Cr), manganese (Mn), nickel (Ni), copper (Cu), zinc (Zn), gallium (Ga), zirconium (Zr), niobium (Nb), molybdenum (Mo), lead (Pd), argentum (Ag), cadmium (Cd), indium (In), tin (Sn), lanthanum (La), hafnium (Hf), tantalum (Ta), tungsten (W), iridium (Ir), platinum (Pt), aurum (Au), bismuth (Bi), etc., and/or an alloy thereof.

The gate electrode 170, the source electrode 180, and the drain electrode 190 are each shown as a single layer, but one or more embodiments are not limited to the example, and the gate electrode 170, the source electrode 180, and the drain electrode 190 may each have a multi-layered structure including other material layers than the electrode material, independently.

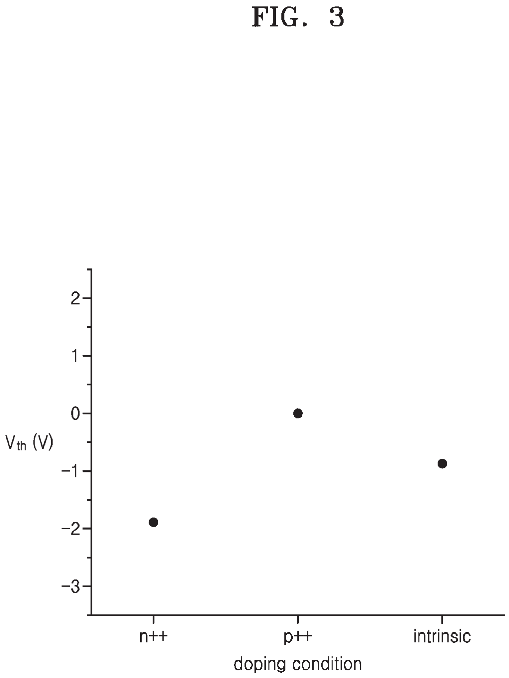

FIG. 3 is a graph showing an experiment of a threshold voltage according to a doping state of the interlayer 150 included in the semiconductor device according to the embodiment.

A transverse axis of the graph denotes the doping state of the interlayer 150. FETs adopting n++ Si, p++ Si, and intrinsic Si in the interlayer 150 show different threshold voltages, and magnitudes of the threshold voltages are shown in an order of n++<intrinsic<p++. From this, it is identified that the doping of the channel layer 140 may be adjusted according to the work function of the interlayer 150.

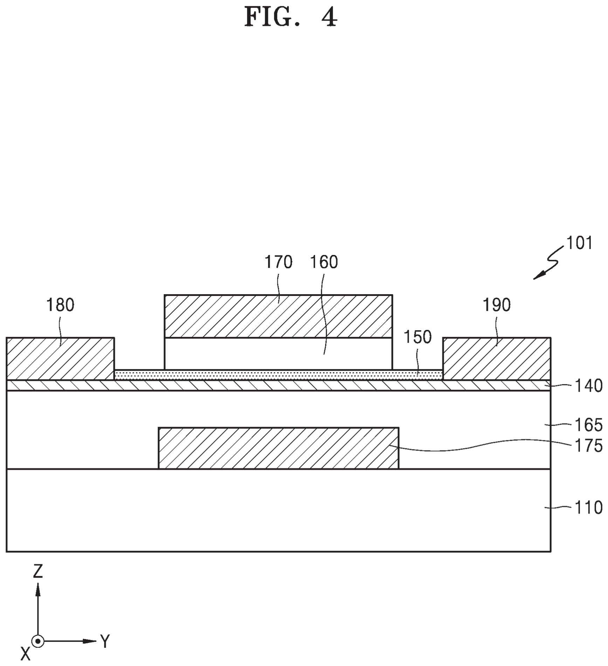

FIG. 4 is a cross-sectional view schematically showing a structure of a semiconductor device 101 according to at least one example embodiment.

The semiconductor device 101 differs from the semiconductor device 100 of FIG. 1 in view of further including a lower gate electrode 175 and a lower gate insulating layer 165, and the other components are substantially the same as (or substantially similar to) those of the semiconductor device 100.

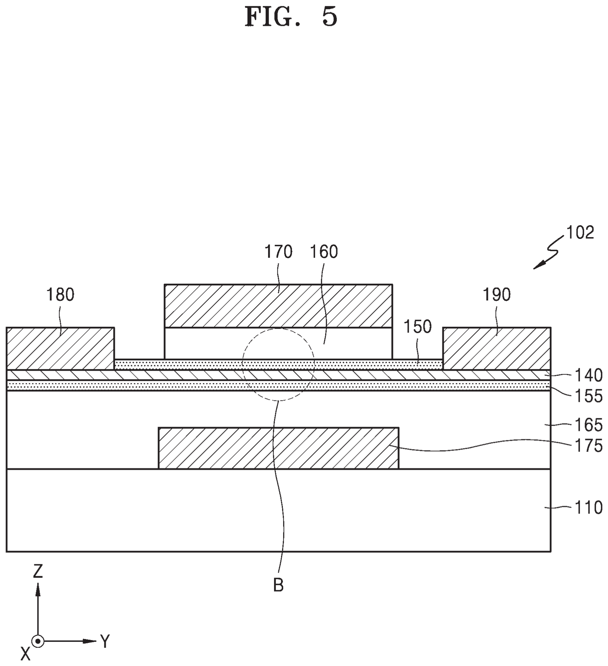

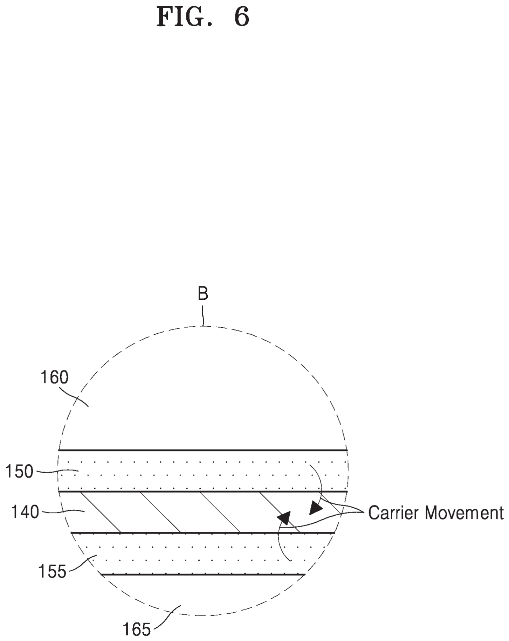

FIG. 5 is a cross-sectional view schematically showing a structure of a semiconductor device 102 according to at least one example embodiment. FIG. 6 is an enlarged view of a part of FIG. 5.

The semiconductor device 102 differs from the semiconductor device 101 of FIG. 4 in view of further including a lower interlayer 155 arranged under the channel layer 140.

The carrier supply to the channel layer 140 may sufficiently occur due to the interlayer 150 and the lower interlayer 155 that are formed adjacent to the upper and lower surfaces of the channel layer 140. The threshold voltage of the semiconductor device 102 may be effectively controlled.

The semiconductor devices 100, 101, and 102 described above are examples having planar type channels, but the example embodiments are not limited thereto, and may be applied as a FinFET, gate-all-around FET (GAAFET), or multi-bridge channel FET (MBCFET) having three-dimensional channel structures so as to increase current and easily control the gate.

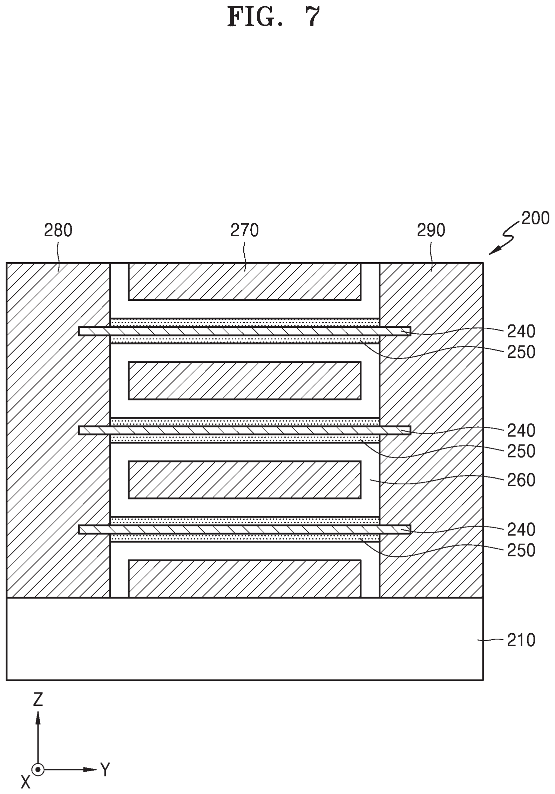

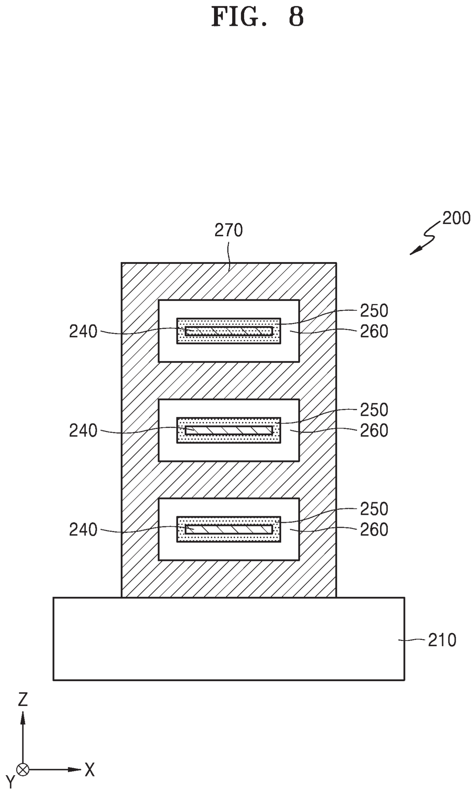

FIG. 7 is a cross-sectional view schematically showing a structure of a semiconductor device 200 according to at least one example embodiment. FIG. 8 is a cross-sectional view showing the semiconductor device of FIG. 7 in different section.

The semiconductor device 200 is a GAA-type FET having multi-bridge channel shape.

The semiconductor device 200 includes a plurality of channel layers 240, and a gate electrode 270 that is spaced apart from each of the plurality of channel layers 240 and surrounds each of the plurality of channel layers 240. The plurality of channel layers 240 may be arranged on a substrate 210. The plurality of channel layers 240 may be spaced apart from one another in a direction away from the substrate 210 (e.g., the Z-direction). A plurality of interlayers 250 surrounding the plurality of channel layers 240 and a plurality of gate insulating layers 260 may be arranged between the gate electrode 270 and the plurality of channel layers 240. The number of channel layers 240 is three, but is not limited thereto, and may include two or more layers.

A source electrode 280 electrically connected to one ends of the plurality of channel layers 240 and a drain electrode 290 electrically connected to the other ends of the plurality of channel layers 240 may be arranged on the substrate 210.

Otherwise, the descriptions about the substrate 110, the channel layer 140, the interlayer 150, the gate insulating layer 160, the gate electrode 170, the source electrode 180, and the drain electrode 190 described above with reference to FIG. 1 may be similarly applied to the substrate 210, the channel layers 240, the interlayers 250, the gate insulating layer 260, the gate electrode 270, the source electrode 280, and the drain electrode 290.

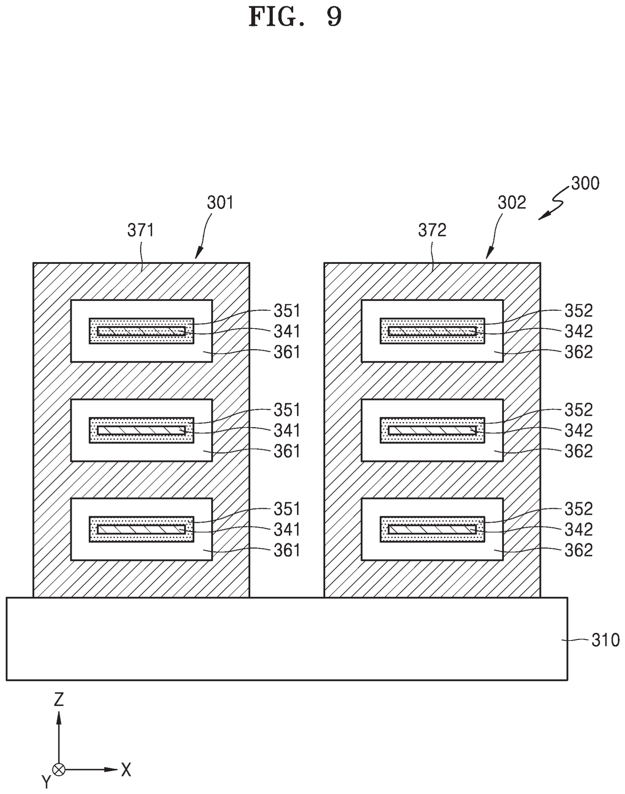

FIG. 9 is a cross-sectional view schematically showing a structure of a semiconductor device 300 according to at least one example embodiment.

The semiconductor device 300 includes a substrate 310, and a first transistor 301 and a second transistor 302 that are spaced apart from each other on the substrate 310.

The first transistor 301 includes a plurality of channel layers 341, and a gate electrode 371 that is spaced apart from each of the plurality of channel layers 341 and surround each of the plurality of channel layers 341.

A plurality of interlayers 351 and a plurality of gate insulating layers 361 are arranged between the plurality of channel layers 341 and a gate electrode 371. Each of the plurality of interlayers 351 may surround each of the plurality of channel layers 341, and each of the plurality of gate insulating layers 361 may surround each of the plurality of interlayers 351.

The second transistor 302 includes a plurality of channel layers 342, and a gate electrode 372 that is respectively spaced apart from each of the plurality of channel layers 342 and surround each of the plurality of channel layers 342.

A plurality of interlayers 352 and a plurality of gate insulating layers 362 are arranged between the plurality of channel layers 342 and the gate electrode 372. Each of the plurality of interlayers 352 may surround each of the plurality of channel layers 342, and each of the plurality of gate insulating layers 362 may surround each of the plurality of interlayers 352.

The descriptions about the channel layer 140, the interlayer 150, the gate insulating layers 361 and 362, and the gate electrodes 371 and 372 described above may be similarly applied independently to the channel layers 341 and 342, the interlayers 351 and 352, the gate insulating layers 361 and 362, and the gate electrodes 371 and 372.

The first transistor 301 may be an N-type FET and the second transistor 302 may be a P-type FET. The channel layer 341 of the first transistor 301 and the channel layer 342 of the second transistor 302 may include different materials from each other. For example, the channel layer 341 of the first transistor 301 may include MoS₂ and the channel layer 342 of the second transistor 302 may include WSe₂.

The first transistor 301 and the second transistor 302 may have threshold voltages of the same (or substantially similar) magnitude. A concentration of a dopant doped on the interlayer 351 of the first transistor 301 and a concentration of a dopant doped on the interlayer 352 of the second transistor 302 may be different from each other. In other words, the channel layer 341 of the first transistor 301 and the channel layer 342 of the second transistor 302 may adopt different materials, and the threshold voltages of the same magnitude level may be implemented in the manner of adjusting the doping concentration of each of the interlayers 351 and 352.

However, the example embodiments are not limited thereto, and the dopant concentration doped on the interlayer 351 of the first transistor 301 and the dopant concentration doped on the interlayer 352 of the second transistor 302 may be the same as each other.

In at least one example embodiment, a semiconductor device may include a plurality of transistors having different threshold voltages. The plurality of transistors may have the same (or substantially similar) base material in the channel layers and different materials in the interlayers or doping concentrations.

In at least one example embodiment, the semiconductor device may include a plurality of transistor having different threshold voltages. Some of the plurality of transistors may have the same or substantially similar base material in the channel layers, and some other transistors may have different materials in the channel layers. In the plurality of transistors, the materials or doping concentrations of the interlayers may be equal to or different from each other.

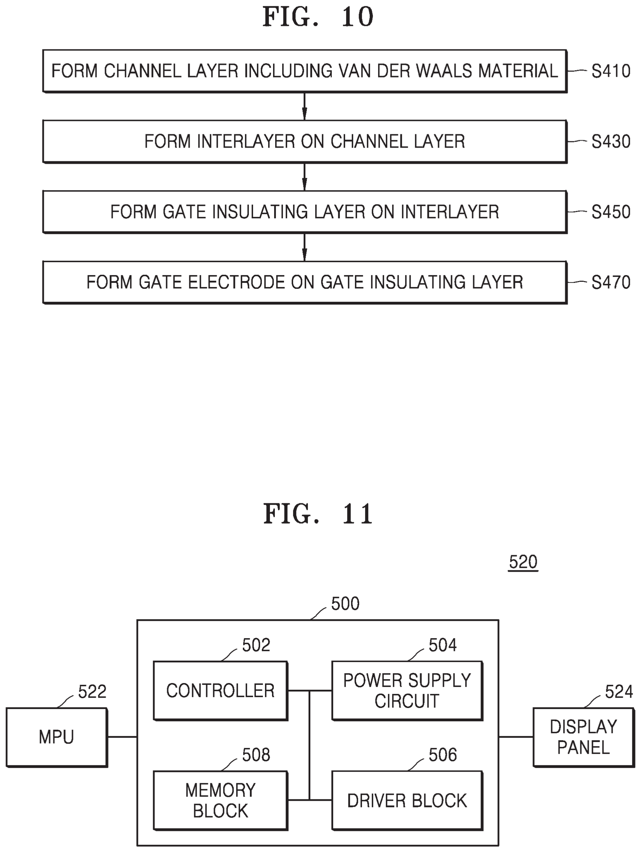

FIG. 10 is a flowchart schematically illustrating a method of manufacturing a semiconductor device, according to at least one example embodiment.

The method of manufacturing a semiconductor device includes a step of forming a channel layer including a van der Waals material (S410), a step of forming an interlayer including a semiconductor or insulator and a dopant in the channel layer (S430), a step of forming a gate insulating layer on the interlayer (S450), and a step of forming a gate electrode on the gate insulating layer (S470).

The descriptions about the channel layer, the interlayer, the gate insulating layer, and the gate electrode described above may apply to materials and structures of the channel layer, the interlayer, the gate insulating layer, and the gate electrode manufactured in respective steps.

The channel layer may be formed by a metal organic CVD (MOCVD) method, an ALD method, etc.

The interlayer may be formed by a PVD method. For example, the interlayer may be formed by evaporating a target material which includes a semiconductor material doped with a dopant of a certain type and concentration. The interlayer may be formed by, for example, a thermal evaporation, an e-beam evaporation method, or may be formed by a sputtering method. However, one or more embodiments are not limited thereto, and the interlayer may be formed by the method such as an ALD method or a CVD method provided that a desired dopant may be appropriately added to the interlayer.

A concentration of the dopant contained in the interlayer may be 1×10¹³ per cubic centimeter (cm⁻³) or greater, and the thickness of the interlayer may be 1 nm or less.

During the manufacturing processes, the source electrode and the drain electrode electrically contacting both ends of the channel layer may be formed.

Detailed processes may be further added according to specific shape of the semiconductor device to be manufactured, that is, according to whether the semiconductor device is a planar type or a GAA type.

The semiconductor device according to the embodiments and the semiconductor device provided according to the manufactured method of the embodiment may show excellent electric performance with ultra small structure and may be applied to an integrated circuit device. The semiconductor device according to the embodiments may be utilized as a logic transistor and may be applied to various electronic apparatuses along with a controller controlling the logic transistor.

The semiconductor devices 100, 101, 102, 200, and/or 300 described above may be used in, for example, a driving integrated circuit of a display, a complementary metal oxide semiconductor (CMOS) inverter, a CMOS SRAM device, a CMOS NAND circuit, and/or other various electronic apparatuses.

FIG. 11 is a schematic block diagram of a display driver integrated circuit (IC) (DDI) and a display apparatus including the DDI, according to at least one example embodiment.

Referring to FIG. 11, the DDI 500 may include a controller 502, a power supply circuit 504, a driver block 506, and a memory block 508. The controller 502 receives and decodes commands applied from a main processing unit (MPU) 522, and controls each block in the DDI 500 for implementing operations according to the commands. The power supply circuit 504 generates a driving voltage in response to the control from the controller 502. The driver block 506 drives a display panel 524 by using the driving voltage that is generated by the power supply circuit 504 in response to the control from the controller 502. The display panel 524 may include, for example, a liquid crystal display panel, an organic light-emitting device (OLED) panel, or a plasma display panel. The memory block 508 is a block for temporarily storing commands input to the controller 502 or control signals output from the controller 502, or for storing required data, and may include a memory such as RAM, ROM, etc. One or more of the controller 502, the power supply circuit 504, the driver block 506, and/or the like may each include one or more of the semiconductor devices 100, 101, 102, 200, and/or 300 according to the example embodiments described above, and/or a semiconductor device modified and combined therefrom.

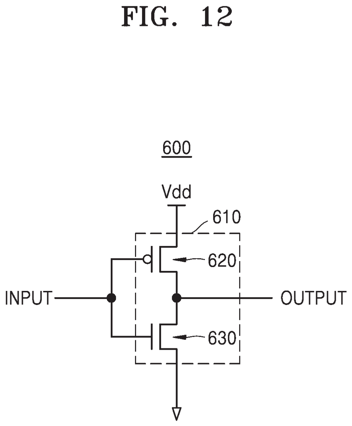

FIG. 12 is a circuit diagram of a CMOS inverter 600 according to at least one example embodiment.

Referring to FIG. 12, the CMOS inverter 600 includes a CMOS transistor 610. The CMOS transistor 610 includes a PMOS transistor 620 and an NMOS transistor 630 connected between a power terminal Vdd and a ground terminal. The CMOS transistor 610 may include one of the semiconductor devices 100, 101, 102, 200, and/or 300 according to the embodiments described above, or a semiconductor device modified and combined therefrom.

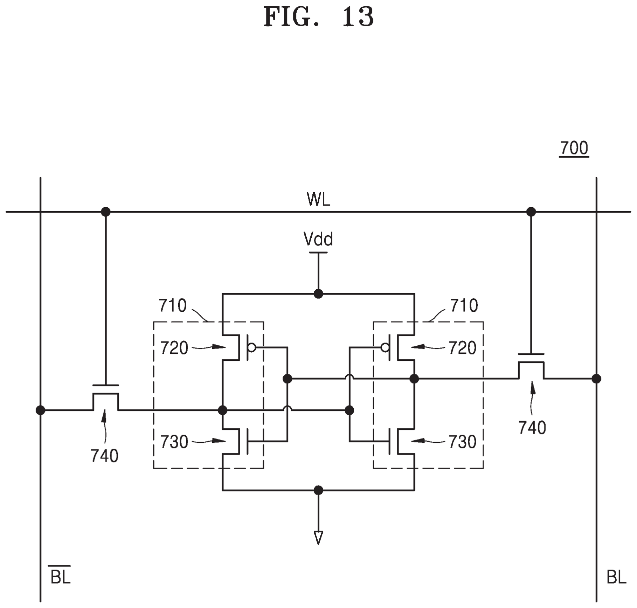

FIG. 13 is a circuit diagram of a CMOS SRAM device 700 according to at least one example embodiment.

Referring to FIG. 13, the CMOS SRAM device 700 includes a pair of driving transistors 710. The pair of transistors 710 each include a PMOS transistor 720 and an NMOS transistor 730 connected between the power terminal Vdd and the ground terminal. The CMOS SRAM device 700 may further include a pair of transfer transistors 740. Sources of the transfer transistors 740 may be cross-connected to common nodes of the PMOS transistor 720 and the NMOS transistor 730 forming the driving transistor 710. The power terminal Vdd is connected to a source of the PMOS transistor 720, and the ground terminal is connected to a source of the NMOS transistor 730. A word line WL may be connected to gates of the pair of transfer transistor 740, and a bit line BL and an inverted bit line may be respectively connected to drains of the pair of transfer transistors 740. At least one of the driving transistor 710 and the transfer transistor 740 of the CMOS SRAM device 700 may include one or more of the semiconductor devices 100, 101, 102, 200, and/or 300 according to the example embodiments described above, or a semiconductor device modified and combined therefrom.

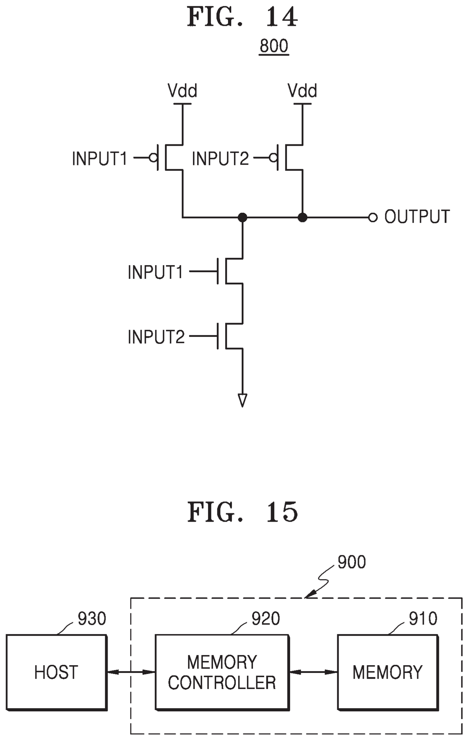

FIG. 14 is a circuit diagram of a CMOS NAND circuit 800 according to at least one example embodiment.

Referring to FIG. 14, the CMOS NAND circuit 800 may include a pair of CMOS transistors to which different input signals are transferred. The CMOS NAND circuit 800 may include one or more of the semiconductor devices 100, 101, 102, 200, and/or 300 according to the example embodiments described above, or a semiconductor device modified and combined therefrom.

FIG. 15 is a block diagram of an electronic device 900 according to at least one example embodiment.

Referring to FIG. 15, the electronic device 900 includes a memory 910 and a memory controller 920. The memory controller 920 may control the memory 910 in response to a request from a host 930, for reading and/or writing data from/into the memory 910. At least one of the memory 910 and/or the memory controller 920 may include one or more of the semiconductor devices 100, 101, 102, 200, and/or 300 according to the embodiments described above, or a semiconductor device modified and combined therefrom.

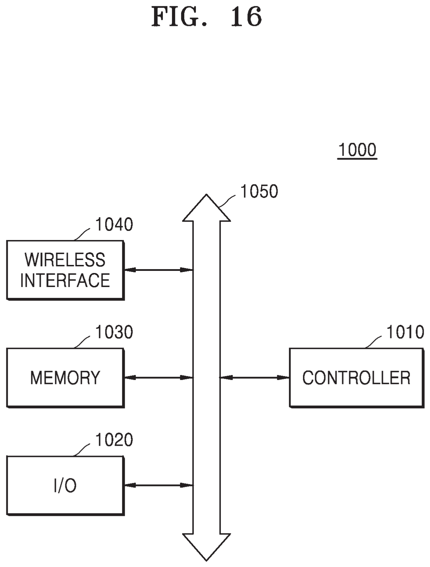

FIG. 16 is a block diagram of an electronic device 1000 according to at least one example embodiment.

Referring to FIG. 16, the electronic device 1000 may configure a wireless communication device or a device capable of transmitting and/or receiving information under wireless environment. The electronic device 1000 includes a controller 1010, an input/output device (I/O) 1020, a memory 1030, and a wireless interface 1040, which are connected to one another via a bus 1050.

The controller 1010 may include a microprocessor, a digital signal processor, or at least one of similar processing devices. The I/O 1020 may include at least one of a keypad, a keyboard, and a display. The memory 1030 may be used to store commands executed by the controller 1010. For example, the memory 1030 may be used to store user data. The electronic device 1000 may use the wireless interface 1040 for transmitting/receiving data via a wireless communication network. The wireless interface 1040 may include an antenna and/or a wireless transceiver. In some embodiments, the electronic device 1000 may be used in a communication interface protocol of a third-generation communication system, for example, code division multiple access (CDMA), global system for mobile communication (GSM), north American digital cellular (NADC), extended-time division multiple access (E-TDMA), and/or wide band code division multiple access (WCDMA). The electronic device 1000 may include one or more of the semiconductor devices 100, 101, 102, 200, and/or 300 according to the example embodiments described above, or a semiconductor device modified and combined therefrom.

The above semiconductor device may have a structure that is miniaturized and is easy to represent a desired threshold voltage.

The semiconductor device may represent various threshold voltages and may be easily applied to a logic design, and may be applied to various electronic devices.

It should be understood that the example embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a channel layer including a van der Waals material;
an interlayer on the channel layer, the interlayer including at least one of a semiconductor or an insulator, and a dopant in the at least one of the semiconductor or insulator;
a gate insulating layer on the interlayer; and
a gate electrode on the gate insulating layer such that the gate insulating layer separates the gate electrode from the interlayer.

2. The semiconductor device of claim 1, wherein the channel layer includes at least one of a two-dimensional semiconductor, graphene, carbon nano-tube, or phosphorene,
wherein the two-dimensional semiconductor preferably includes at least one of MoS₂, WS₂, MoSe₂, MoTe₂, WSe₂, WTe₂, ReS₂, ReSe₂, PtS₂, PtSe₂, NbS₂, NbSe₂, SnS₂, SnS, SnSe, or SnSe₂.

3. The semiconductor device of claim 1 or 2, wherein the interlayer is configured
as a seed layer with respect to the gate insulating layer, and
as a doping layer with respect to the channel layer.

4. The semiconductor device of one of claims 1 to 3, wherein the interlayer includes a physical vapor deposition, PVD, deposited material formed directly on the channel layer, or
wherein the interlayer includes at least one of Si, Ge, or a group III-V semiconductor compound.

5. The semiconductor device of one of claims 1 to 4, wherein a doping concentration of a dopant in the interlayer is 1×10¹³ per cubic centimeter, cm⁻³, or greater.

6. The semiconductor device of one of claims 1 to 5, wherein the interlayer has a thickness of 1 nanometer, nm, or less.

7. The semiconductor device of one of claims 1 to 6, further comprising:
a lower gate electrode under the channel layer; and
a lower gate insulating layer between the lower gate electrode and the channel layer,
wherein the semiconductor device preferably comprises:
a lower interlayer between the channel layer and the lower gate insulating layer, the lower interlayer including at least one of a semiconductor or an insulator, and a dopant in the at least one of the semiconductor or insulator.

8. The semiconductor device of one of claims 1 to 7, wherein
the channel layer is a first channel layer,
the semiconductor device includes a second channel layer spaced apart the first channel layer,
the interlayer is a first interlayer surrounding the first channel layer,
the semiconductor device includes a second interlayer surrounding the second channel layer, and
the gate electrode surrounds each of the first interlayer and the second interlayer.

9. The semiconductor device of claim 1 further comprising:
a substrate; and
a first transistor and a second transistor on the substrate, the first transistor and the second transistor spaced apart from each other,
wherein the first transistor includes the channel layer, the interlayer, the gate insulating layer, and the gate electrode, and
wherein the second transistor independently includes a second channel layer including the van der Waals material, a second interlayer on the second channel layer, the second interlayer including at least one of the semiconductor or the insulator, and the dopant in the at least one of the semiconductor or insulator, a second gate insulating layer on the second interlayer, and a second gate electrode on the second gate insulating layer such that the second gate insulating layer separates the second gate electrode from the second interlayer.

10. The semiconductor device of claim 9, wherein the first transistor is an N-type field-effect transistor, FET, and the second transistor is a P-type FET, and
wherein the first transistor and the second transistor preferably represent threshold voltages of a substantially same magnitude.

11. The semiconductor device of claim 9, wherein a doping concentration of the dopant in the interlayer in the first transistor is different from a doping concentration of the dopant in the interlayer of the second transistor.

12. The semiconductor device of claim 9, wherein the first transistor and the second transistor represent different threshold voltages,
wherein preferably the channel layer of the first transistor and the channel layer of the second transistor include a same base material, and
wherein preferably a doping concentration of the dopant in the interlayer in the first transistor is different from a doping concentration of the dopant in the interlayer of the second transistor.

13. The semiconductor device of claim 9, wherein, in each of the first transistor and the second transistor,
the channel layer is a first channel layer, and a second channel layer is spaced apart from the first channel layer,
the interlayer is a first interlayer surrounding the first channel layer, and a second interlayer surrounds the second channel layer, and
the gate electrode surrounds each of the first interlayer and the second interlayer.

14. A method of manufacturing a semiconductor device, the method comprising:
providing a channel layer including a van der Waals material;
forming an interlayer on the channel layer, the interlayer including at least one of a semiconductor or an insulator, and a dopant in the at least one of the semiconductor or insulator;
forming a gate insulating layer on the interlayer; and
forming a gate electrode on the gate insulating layer.

15. An electronic device comprising:
at least one of the semiconductor device of one of claims 1 to 13; and
a controller configured to control the at least one of the semiconductor device.
